# EUROPEAN PATENT SPECIFICATION

(11) **EP 2 086 723 B1**
(45) Date of publication and mention of the grant of the patent: **13.02.2013**
(21) Application number: 07835240.8
(22) Date of filing: 28.11.2007
(51) Int. Cl.: B25B 23/147, H05K 1/02, B25F 5/00, B25B 21/00, B25B 23/14, H05K 7/14

(54) **POWER TOOL WITH ELECTRONIC CONTROL UNIT**
KRAFTBETRIEBENES WERKZEUG MIT ELEKTRONISCHER STEUEREINHEIT
OUTIL ÉLECTRIQUE À UNITÉ DE COMMANDE ÉLECTRONIQUE

(30) Priority: 01.12.2006 SE 0602574
(43) Date of publication of application: 12.08.2009
(73) Proprietor: Atlas Copco Industrial Technique AB, 105 23 Stockholm (SE)
(72) Inventor: ÖSTLING, Carl Gunnar, 131 34 Nacka (SE)
(86) International application number: PCT/SE2007/001049
(87) International publication number: WO 2008/066453

(56) References cited:
- EP-A2- 1 321 237
- EP-A2- 1 733 845
- US-A- 2 876 277
- US-A- 4 400 858
- US-A1- 2002 069 730
- US-A1- 2002 069 730
- US-A1- 2004 040 727

## Description

The invention relates to an electric power tool according to the preamble of claim 1, an example of which is known from US 2002 0069730.

In electric power tools of this type there is a difficulty to arrange conductors for conducting the high magnitude currents required to energize the motor of the tool. Such high magnitude currents are normally not possible to handle via the leads formed on circuit boards, because such leads could have small areas only and would cause very intense heat that would be detrimental to the electronic components carried on the circuit board. Instead, high magnitude current leads connecting the motor to a power source have normally been formed by a separate wiring which is space demanding and tricky to handle together with the circuit board or boards at the assembly of the tool.

Another problem concerned with this type of tools is the mechanical strength and durability of the circuit boards and, when applicable, also the connections between two or more circuit boards. Power tools are often exposed to accidental violent external forces during use which might cause damage to the circuit boards with loose shaken components etc. Also at assembly of the power tool there are situations where the sensitive circuit boards are exposed to damage risks.

Still another problem is to effectively duct away heat generated in certain electronic components and hence in certain areas of the circuit boards to avoid overheating of and damage to the components.

The main object of the invention is to provide an electric power tool with an onboard electronic operation control unit by which the above mentioned problems are avoided. This is obtained by providing high capacity motor current leads which also act as mechanical reinforcement means as well as heat ducting means for the circuit boards of the operation control unit.

Further characteristics and advantages of the invention will appear from the following specification and claims.

A preferred embodiment of the invention is below described in detail with reference to the accompanying drawing.

In the drawing
Fig. 1 shows a perspective view, partly in section, of an electric power tool according to the invention.
Fig. 2 shows a perspective view of the operation control unit included in the power tool in Fig. 1.
Fig. 3 shows a fractional perspective view, partly in section, of the circuit board arrangement of the operation control unit in Fig. 2.
Fig. 4 shows a cross section through the operation control unit.

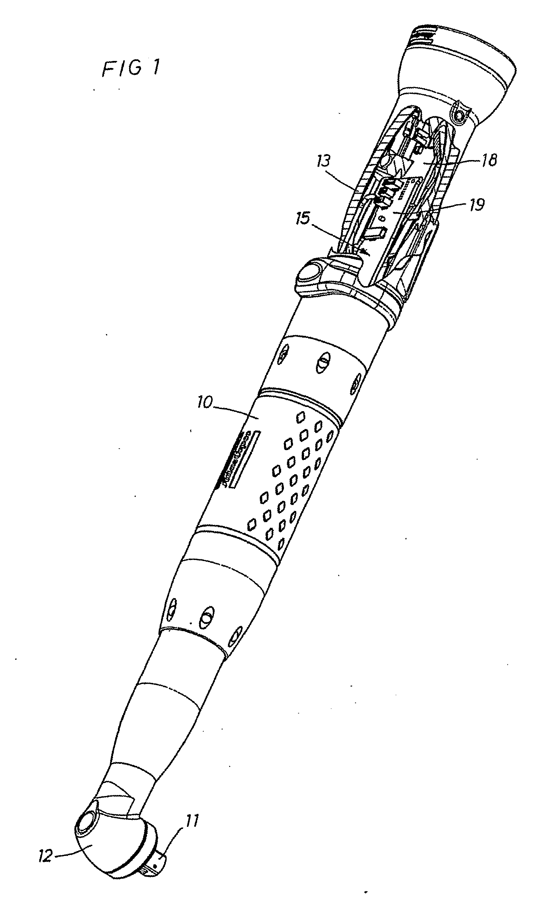

The power tool illustrated in Fig. 1 is an electric angle nutrunner including a housing 10 with a non-illustrated electric motor connected to an output shaft 11 extending from an angle head 12 at the forward end of the housing 10.

At its rear end the housing 10 is formed with a handle 13 for manual support of the tool. At the rear end of the handle 13 there is a non-illustrated connection means for connecting the tool via a cable to a stationary process control unit, and inside the handle 13 there is supported an electronic operation control unit 15. The latter is connected to the external connection means at the rear end of the handle as well as to the motor and to operation parameter responsive sensors, like for instance heat a sensor, that are usually supported in the housing 10.

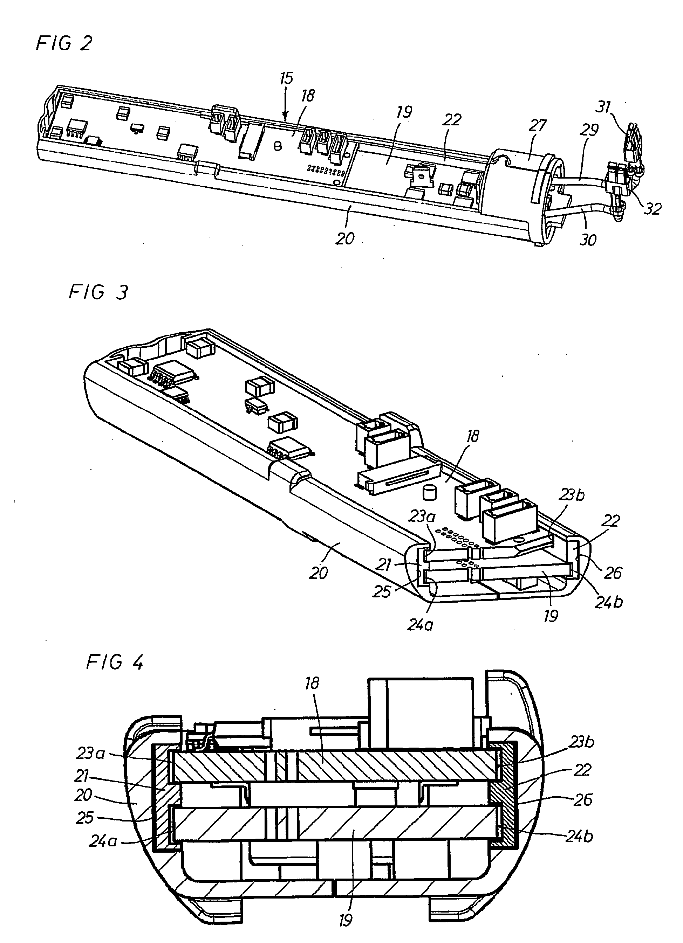

The control unit 15 comprises two printed circuit boards 18,19 carrying electronic components connected to the motor and the sensors and arranged to supply motive power to the motor. As best illustrated in Figs. 3 and 4, the printed circuit boards 18,19 are supported by two elongate rigid metal bars 21,22 extending along the sides of the circuit boards 18,19. These bars 21,22 are provided with grooves 23a,b and 24a,b, respectively, extending in the longitudinal direction of the bars 21,22 and in which the side edges of the circuit boards 18,19 are received, whereby the bars 21,22 serve as rigid reinforcement means for the circuit boards 18,19. The bars 21,22 are made of copper and are used as leads for the high magnitude motor currents, and due to the large area of these leads formed by the bars 21,22 the motor currents will not generate any heat. Instead, the copper bars 21,22 act as heat transferring means by ducting away heat generated by some of the electronic components in certain areas of on the circuit boards 18,19.

The entire control unit assembly, including the circuit boards 18,19 with the electronic components and the bars 21,22 are mounted in the tool housing 10 via a nonconductive casing 20. The latter is formed as an elongate tray with two parallel inner channels 25,26 on its side walls for receiving the bars 21,22. At its rear end the casing 20 is formed with a tubular portion 27 for proper orientation in the longitudinal direction of the tool housing 10. Preferably, the casing 20 is made of a suitable plastic material. From the rear end of the casing 20 there extend two sets of conductors 29,30 provided with connectors 31,32 for connection to the non-illustrated connection means at the rear end of the housing 10.

By designing the control unit 15 as a subassembly including the circuit boards 18,19, the motor current leading and circuit board reinforcing bars 21,22 and the casing 20 there is obtained a robust preassembled unit which is easy to merge with power tool housing 10 at the final assembly of the power tool without risking any damage to the separate parts of the control unit.

## Claims

1. Electric power tool comprising a housing (10), an electric motor, and an onboard operation control unit (15) for motor power supply control, wherein
the control unit (15) comprises
at least one printed circuit board (18,19) carrying electronic components,
**characterized in that** the control unit (15) comprises at least one rigid metal bar (21,22) extending along at least a part of said circuit board or boards (18,19) and being provided with longitudinal grooves (23a,b, 24a,b) for receiving side edges of said circuit board or boards (18,19), wherein
said at least one metal bar (21,22) is arranged to form a lead for the electric motor current.

2. Power tool according to claim 1, wherein said metal bars (21,22) are two in number and extend substantially in parallel with each other and along opposite side edges of said at least one printed circuit board (18,19).

3. Power tool according to claim 2, wherein said metal bars (21,22) are received in an electrically no-conducting support casing (20) arranged to form a support for said circuit board or boards (18,19) and said metal bars (21,22) relative to the housing (10).

4. Power tool according to claim 3, wherein said support casing (20) has the form of a tray with two parallel channels (25,26) for receiving said metal bars (21,22).

5. Power tool according to claim 3 or 4, wherein said casing (20) together with said circuit board or boards (18,19) and said metal bars (21,22) form a subassembly for merging with the housing (10) at assembly of the power tool.

## Patentansprüche

1. Elektrisch betriebenes Werkzeug, umfassend ein Gehäuse (10), einen Elektromotor und eine integrierte Betriebssteuereinheit (15) zur Steuerung der Motorstromversorgung, wobei die Steuereinheit (15) Folgendes umfasst
mindestens eine Leiterplatte (18, 19), die elektronische Bauteile trägt,
**dadurch gekennzeichnet, dass** die Steuereinheit (15) mindestens eine steife Metallstange (21, 22) umfasst, die entlang von zumindest einem Teil der Platine oder Platinen (18, 19) verläuft und mit Längsrillen (23a,b, 24a,b) zum Aufnehmen von Seitenkanten der Platine oder Platinen (18, 19) versehen ist, wobei
die mindestens eine Metallstange (21, 22) angeordnet ist, um eine Leitung für den Elektromotorstrom zu bilden.

2. Elektrowerkzeug nach Anspruch 1, bei dem die Anzahl der Metallstangen (21, 22) zwei ist und sie im Wesentlichen parallel zueinander und entlang gegenüberliegenden Seitenkanten der mindestens einen Leiterplatte (18, 19) verlaufen.

3. Elektrowerkzeug nach Anspruch 2, bei dem die Metallstangen (21, 22) in einem elektrisch nichtleitenden Trägergehäuse (20) aufgenommen sind, das angeordnet ist, um einen Träger für die Platine oder Platinen (18, 19) und die Metallstangen (21, 22) bezogen auf das Gehäuse (10) zu bilden.

4. Elektrowerkzeug nach Anspruch 3, bei dem das Trägergehäuse (20) die Form eines Fachs mit zwei parallelen Kanälen (25, 26) zum Aufnehmen der Metallstangen (21, 22) aufweist.

5. Elektrowerkzeug nach Anspruch 3 oder 4, bei dem das Gehäuse (20) zusammen mit der Platine oder den Platinen (18, 19) und den Metallstangen (21, 22) eine Montagegruppe zum Zusammenfügen mit dem Gehäuse (10) während der Montage des Elektrowerkzeugs bildet.

## Revendications

1. Outil électrique comprenant un boîtier (10), un moteur électrique, et une unité de commande de fonctionnement (15) intégrée pour la commande de l'alimentation électrique du moteur, dans lequel l'unité de commande (15) comprend
au moins une carte de circuit imprimé (18, 19) portant des composants électroniques,
**caractérisé en ce que** l'unité de commande (15) comprend au moins une barre métallique rigide (21, 22) s'étendant le long d'au moins une partie de ladite carte ou desdites cartes de circuit (18, 19) et étant pourvue de rainures longitudinales (23a,b, 24a,b) pour recevoir des bords latéraux de ladite carte ou desdites cartes de circuit (18, 19), dans lequel
ladite au moins une barre métallique (21, 22) est disposée pour former un conducteur pour le courant du moteur électrique.

2. Outil électrique selon la revendication 1, dans lequel lesdites barres métalliques (21, 22) sont au nombre de deux et s'étendent essentiellement parallèles l'une à l'autre et le long de bords latéraux opposés de ladite au moins une carte de circuit imprimé (18, 19).

3. Outil électrique selon la revendication 2, dans lequel lesdites barres métalliques (21, 22) sont reçues dans un logement de support (20) non conducteur électriquement, disposé pour former un support pour ladite carte ou lesdites cartes de circuit (18, 19) et lesdites barres métalliques (21, 22) par rapport au boîtier (10).

4. Outil électrique selon la revendication 3, dans lequel ledit logement de support (20) présente la forme d'un plateau avec deux canaux parallèles (25, 26) pour recevoir lesdites barres métalliques (21, 22).

5. Outil électrique selon la revendication 3 ou 4, dans lequel ledit logement (20) avec ladite carte ou lesdites cartes de circuit (18, 19) et lesdites barres métalliques (21, 22) forment un sous-ensemble pour s'unir avec le boîtier (10) lors de l'assemblage de l'outil électrique.
